# EUROPÄISCHE PATENTANMELDUNG

(11) **EP 2 309 831 A1**
(43) Veröffentlichungstag der Anmeldung: **13.04.2011**
(21) Anmeldenummer: 09012750.7
(22) Anmeldetag: 08.10.2009
(51) Int. Cl.: H05K 3/20, H05K 1/11, H05K 3/18, H05K 3/46

(54) **Verfahren zur Herstellung einer Leiterplatte, insbesondere Mehrlagenleiterplatte**

(71) Anmelder: ZYRUS Beteiligungsgesellschaft mbH & Co. Patente I KG, 12529 Schönefeld / OT Waltersdorf (DE)
(72) Erfinder: Uelzen, Thorsten, Dr., 21698 Bargstedt (DE); Rostami, Bardia, Dr., 22299 Hamburg (DE); Tode, Siegfried, 01307 Dresden (DE)
(74) Vertreter: Rohnke, Christian

(57) **Zusammenfassung**

Verfahren zur Herstellung einer Leiterplatte, umfassend die Schritte: Bereitstellen einer ersten Elektrode (10), deren Oberfläche mindestens bereichsweise aus leitfähigem Polymer gebildet ist und die mindestens einen Bereich (11) einer vorgegebenen Struktur mit gegenüber den übrigen Bereichen erhöhter Leitfähigkeit aufweist; Aufbringen einer ersten Metallschicht (15) auf das Polymer durch Galvanisieren derart, dass die Metallschicht (15) die Struktur des leitfähigen Bereichs (11) im Wesentlichen übernimmt; Bereitstellen einer ersten Isolationsschicht (16); Übereinanderanordnung von erster Metallschicht (15) und erster Isolationsschicht (16) zur Ausbildung der Leiterplatte; und Schaffung einer durch die Isolationsschicht (16) durchgehende Ausnehmung (26), die zumindest teilweise auch durch die erste Metallschicht begrenzt ist.

## Beschreibung

Die Erfindung betrifft ein Verfahren zur Herstellung einer Leiterplatte, insbesondere Mehrlagenleiterplatte nach Anspruch 1.

Eine Leiterplatte umfasst üblicherweise einen starren oder flexiblen Träger aus isolierendem Material, auf dem elektrisch leitfähige Verbindungen vorgesehen sind. Der starre oder flexible Träger dient insbesondere der mechanischen Befestigung der elektrischen Verbindung und elektronischen Bauteile.

Bezüglich der Erzeugung elektrisch leitfähiger Strukturen auf Leiterplatten ist aus dem Stand der Technik eine Vielzahl unterschiedlicher Verfahren bekannt. Die Verfahren unterscheiden sich in Bezug auf den jeweils erforderlichen aparativen Aufwand, die mit ihm erzielbare Auflösung, Oberflächengüte und die Herstellungsverfahrensgeschwindigkeit. Die Leiterplatten zur elektrischen Verbindung der elektronischen Bauteile werden üblicherweise durch Ätzen, beispielsweise Masken-ätzen, geeignete Druckverfahren oder Laserapplikationen aufgebracht.

In diesem Zusammenhang sind aus dem Stand der Technik Leiterbahnen bekannt, bei denen die elektronischen Bauelemente, Baugruppen und Anwendungen vollständig oder teilweise mittels geeigneter Druckverfahren auf den Leiterplatten appliziert werden. In diesem Fall werden beispielsweise anstelle von Druckfarben elektronische Funktionsmaterialien, die in flüssiger oder pastöser Form vorliegen, verdruckt.

Eine weitere Möglichkeit der Herstellung von Leiterbahnen ist das so genannte Flexodruck-Verfahren. Hierbei werden zunächst auf einem insbesondere flexiblen Polymer, insbesondere PET (Polyethylenterephthalat) oder PC (Polycarbonat), Strukturen aus Metall aufgebracht. Eine Rückseite der Polymere wird mit einem Primär versehen, so dass die Polymerfolie auf einer Leiterplatte aufgeklebt werden kann. Im Anschluss an das Aufkleben der Folie auf die Leiterplatte wird schließlich die Folie, zumindest zwischen den metallischen Leiterbahnen, entfernt.

Von den zum Einsatz kommenden Laserbehandlungsverfahren zur Erzeugung von Leiterbahnen auf Leiterplatten, sind insbesondere das Laser-Direct-Imaging (LDI) sowie das Laser-Direct-Patterning (LDP) zu nennen. Beim Laser-Direct-Imaging wird zunächst eine Metallisierung, in der Regel flächig, auf eine Leiterplatte aufgebracht. Im Anschluss daran erfolgt die selektive Entfernung der Metallisierung mithilfe eines hochauflösenden Lasers.

Im Gegensatz hierzu wird beim Laser-Direct-Patterning eine Substratfläche mit einem aufgeweiteten Laserkurs strukturiert. Diese Methode hat vor allem den Vorteil, dass sie schneller als das Laser-Direct-Imaging arbeitet, erfordert jedoch sehr dünne Metallschichten.

Durch Kombination mit einem speziellen Wasserstrahl, einem Reinigungsverfahren und einer Rolle-zu-Rolle-Technik, insbesondere Rolle-zu-Rolle-Galvanik, ergänzt sich das Laser-Direct-Patterning auch zur Herstellung von laserstrukturierten, flexiblen Leiterplatten in einer industriellen Serienfertigung.

Den aus dem Stand der Technik bekannten Fertigungsverfahren zur Erzeugung von Leiterbahnen auf Leiterplatten ist gemein, dass ihre Auflösung mit 25µm bis 35µm bei der Laserstrukturierung bzw. Thermoflex-Verfahren sowie 80µm bis 100µm bei Druckverfahren für eine Vielzahl von Anwendungen im Elektronikbereich nicht mehr ausreichend ist.

Der Erfindung liegt die Aufgabe zugrunde, ein Verfahren zur Herstellung einer Leiterplatte, insbesondere Mehrlagenleiterplatte vorzuschlagen, wobei die erzielbare Auflösung bzw. der erzielbare minimale Abstand zwischen den Leiterbahnen reduziert sein soll. Diese Aufgabe wird durch ein Verfahren zur Herstellung einer Leiterplatte nach Patentanspruch 1 gelöst.

Die Aufgabe wird insbesondere durch ein Verfahren zur Herstellung einer Leiterplatte gelöst, wobei das Verfahren folgende Schritte umfasst:
a) Bereitstellen einer ersten Elektrode, deren Oberfläche mindestens bereichsweise aus leitfähigem Polymer gebildet ist oder wird und die mindestens einen Bereich einer vorgegebenen Struktur mit gegenüber den übrigen Bereichen erhöhter Leitfähigkeit aufweist;
b) Aufbringen einer ersten Metallschicht auf das Polymer durch Galvanisieren derart, dass die Metallschicht die Struktur des mindestens einen Bereichs mit erhöhter Leitfähigkeit im Wesentlichen übernimmt;
c) Bereitstellen einer ersten Isolationsschicht;
d) Übereinanderanordnung von erster Metallschicht und erster Isolationsschicht; und
e) Schaffung einer durch die Isolationsschicht durchgehenden Ausnehmung, die zumindest teilweise auch durch die erste Metallschicht begrenzt ist.

Ein wesentlicher Punkt der Erfindung liegt auch darin, dass die Struktur der Leitfähigkeit der ersten Elektrode mit den Galvanisierungsparametern, wie angelegter Spannung bzw. eingestelltem Staufluss und dergleichen, derart abgestimmt wird, dass Metallstrukturen mit der Auflösung der höher leitfähigen Bereiche der ersten Elektrode herstellbar sind. Durch die Schaffung der Ausnehmung im Schritt e) wird die Möglichkeit geschaffen, eine Kontaktierung mit weiteren Komponenten, insbesondere weiteren Metallschichten herzustellen. Gemäß einem unabhängigen Aspekt der Erfindung können die Schritte c) und/oder d) und/oder e) auch entfallen. Ein Verfahren zur Herstellung einer strukturierten Metallschicht umfassend die Schritte a) und b) wird unabhängig beansprucht.

Wenn hier von einer "Schicht" die Rede ist, so kann diese durchgehend oder unterbrochen sein, insbesondere aus mehreren voneinander getrennten Teilschichten bestehen.

Die Bereiche mit erhöhter Leitfähigkeit müssen nicht zwangsläufig an der Oberfläche der Elektrode ausgebildet sein. Letztlich ist es entscheidend, dass bei Anlegung einer Spannung in Oberflächenbereichen oberhalb der Bereiche mit erhöhter Leitfähigkeit ein größerer Strom fließt als in den übrigen Oberflächenbereichen. Dadurch kann bei entsprechender Einstellung der Spannung erreicht werden, dass die Metallschicht während des Galvanisierungsschrittes nur oberhalb bzw. auf den Bereichen erhöhter Leitfähigkeit aufgebracht wird.

Die Leitfähigkeit der Bereiche mit erhöhter Leitfähigkeit kann beispielsweise mindestens 1,1-fach, vorzugsweise 2-fach, weiter vorzugsweise 5-fach, insbesondere mindestens 10-fach gegenüber der Leitfähigkeit der übrigen Bereiche sein. Die Leitfähigkeit der Bereiche mit erhöhter Leitfähigkeit kann beispielsweise im Mittel mindestens 10⁻² S/m, vorzugsweise 10⁻¹ S/m, weiter vorzugsweise 1 S/m oder auch mindestens 10, 100, 500, 1.000, 5.000 oder 10.000 oder 100.000 S/m betragen. Die übrigen Bereiche sind hinsichtlich ihrer Leitfähigkeit abhängig von den angegebenen Werten jeweils geringer.

Die Leitfähigkeit, insbesondere bezüglich der angegebenen Werte, kann eine über die Ausdehnung der Elektrode gemittelte Leitfähigkeit sein. Bei einer plattenförmigen Elektrode entspricht diese Ausdehnung insbesondere der Dicke der Platten. Diese gemittelte Leitfähigkeit bestimmt letztlich den Stromfluss an der Oberfläche und somit die Abscheidung des Metalls beim Schritt des Galvanisierens.

Durch das vorgeschlagene Verfahren können Metallstrukturen mit Auflösungen von bis zu 5 µm erzeugt werden. Durch das Polymer an der Oberfläche der Elektrode können diese Metallstrukturen auch von der Elektrode entfernt werden, was bei einer Elektrode, die ausschließlich aus Metall besteht, nicht möglich wäre. Das Polymer bietet somit eine Möglichkeit die äußerst feinen Strukturen abzulösen und beispielsweise auf eine Isolationsschicht aufzubringen. Das Polymer kann auf der Metallschicht verbleiben oder auch beispielsweise durch Ätzen oder mechanisches Entfernen entfernt werden.

Vorzugsweise wird im Schritt a) die Elektrode aus einem leitfähigen Material, insbesondere Metall bereitgestellt, wobei dessen Oberfläche mindestens einen Bereich einer vorgegebenen Struktur mit gegenüber den übrigen Bereichen erhöhter Leitfähigkeit aufweist und anschließend mit Polymer, insbesondere durch Galvanisieren beschichtet wird. In diesem Fall kann dann beispielsweise das durch Galvanisieren im Schritt c) aufgebrachte Metall aufgrund der Polymerbeschichtung leicht von dem leitfähigen Material, insbesondere Metall der Elektrode entfernt werden.

In einer bevorzugten Ausgestaltung wird im Schritt b) im Wesentlichen nur oberhalb des mindestens einen Bereichs mit erhöhter Leitfähigkeit Polymer aufgebracht. Bei dieser Ausgestaltung weist bereits das Polymer die Struktur der Bereiche mit erhöhter Leitfähigkeit auf, so dass beim Aufbringen des Metalls durch Galvanisieren auch dieses die Strukturen übernimmt.

Vorzugsweise wird zumindest ein Teil der Bereiche mit erhöhter Leitfähigkeit in Kontakt mit einem Elektrolyten gebracht und über der Elektrode ein Stromfluss durch den Elektrolyten erzeugt, wobei auf den mit dem Elektrolyten in Kontakt gebrachten Bereich mit erhöhter Leitfähigkeit ein leitfähiger Polymerfilm der vorgegebenen Struktur gebildet wird. In einem alternativen Verfahren wird in Schritt b) die Elektrode im Wesentlichen ganzflächig mit leitfähigem Polymer beschichtet, wobei das Polymer derart ausgewählt und/oder bezüglich seiner Schichtdicke eingestellt wird, dass beim galvanischen Aufbringen des Metalls oberhalb des mindestens einen Bereichs mit erhöhter Leitfähigkeit ein ausreichender Strom für eine galvanische Abscheidung des Metalls fließt. Hierbei kann das Polymer mittels eines beliebigen Verfahrens, beispielsweise durch Aufdampfen oder Aufspritzen oder chemischem Aufwachsen aufgebracht werden. In jedem Fall ermöglicht das Polymer das Ablösen der Metallstruktur von der Elektrode, wobei die Elektrode auch an der Metallstruktur während eines weiteren Bearbeitungsschrittes oder auch innerhalb eines Endproduktes verbleiben kann.

Aus dem Schritt b) kann das leitfähige Polymer von den übrigen Teilen der Elektrode entfernt werden, bevor die Metallschicht auf das Polymer aufgetragen wird. Dies ist insbesondere dann sinnvoll, wenn das leitfähige Polymer bereits die Struktur der Bereiche mit erhöhter Leitfähigkeit aufweist.

Alternativ kann das leitfähige Polymer im Schritt b) auf der Elektrode verbleiben, wenn die Metallschicht aufgetragen wird. In diesem Fall kann das Polymer, wie oben beschrieben, im Wesentlichen ganzflächig aufgetragen werden, da beim Aufbringen der Metallschicht durch Galvanisieren die Bereiche mit erhöhter Leitfähigkeit den Stromfluss ausreichend beeinflussen können.

Vorzugsweise werden Wände der Ausnehmung zumindest bereichsweise mit einem Metall belegt. Dadurch kann auf einfache Weise eine Durchkontaktierung durch die Isolationsschicht bis zur Metallschicht erreicht werden.

Vorzugsweise ist das erste Metall ein Katalysator, der die galvanische Abscheidung eines weiteren Metalls ermöglicht. In diesem Fall dient das erste Metall lediglich der Bekeimung, wobei das zweite Metall eine dickere leitfähige Schicht ermöglicht. Dieses Herstellungsverfahren ist besonders unaufwendig.

In einer bevorzugten Ausgestaltung wird an die erste Elektrode und/oder eine weitere Elektrode eine Spannung angelegt und diese in Kontakt mit einem Elektrolyten gebracht, so dass die Ausnehmung zumindest teilweise durch galvanische Abscheidung mit einem ersten Metall, insbesondere Kupfer gefüllt wird. Auch hier wird in besonders einfacher Weise eine Durchkontaktierung durch die Isolationsschicht ermöglicht.

In einer bevorzugten Ausführungsform wird insbesondere durch galvanische Abscheidung ein zweites Metall in die Ausnehmung gebracht, das eine geringere Schmelztemperatur als das Metall der ersten Metallschicht und/oder als zuvor in die Ausnehmung eingebrachtes Metall aufweist. Es wird dann gemäß einem bevorzugten Verfahren die Leiterplatte einer Temperatur ausgesetzt, die geringer als die Schmelztemperatur des Metalls/der Metalle der zu kontaktierenden Metallschichten ist und zugleich größer als die Schmelztemperatur des zweiten Metalls ist. So können feste elektrische Kontakte in einfacher Weise hergestellt werden.

Vorzugsweise wird die Leiterplatte oberseitig und/oder unterseitig im Wesentlichen ganzflächig mit Metall beschichtet. Die mit Metall beschichtete Oberseite und/oder Unterseite kann chemisch und/oder lithografisch oder mittels eines anderen Verfahrens strukturiert sein.

Vorzugsweise wird auf der der ersten Metallschicht abgewandten Seite der Isolationsschicht eine zweite Metallschicht, insbesondere hergestellt analog der ersten Metallschicht, angeordnet. Weiter vorzugsweise wird eine weitere Isolationsschicht und/oder Metallschicht auf der Leiterplatte angeordnet, wobei sich insbesondere je eine Isolationsschicht mit einer Metallschicht abwechselt. Selbstverständlich können auch mehrere Metallschichten übereinander angeordnet sein oder mehrere Isolationsschichten. Im Ergebnis wird eine mehrschichtige Leiterplatte geschaffen, die äußerst feine Metallstrukturen aufweist.

Die Ausnehmungen können vor der Übereinanderordnung von zwei oder mehr Schichten oder auch danach vorgesehen werden. Dies hängt unter anderem davon ab, wie viele Metallschichten letztlich miteinander kontaktiert werden sollen.

Die erfindungsgemäß ausgeführten bzw. hergestellten Leiterplatten eignen sich unter anderem zur Verkapselung von Mikrochips, bspw. als Substrat, Interposer oder vorgefertigter Redistributions-Layer.

Weitere Ausführungsformen ergeben sich aus den Unteransprüchen.

Nachfolgend wir die Erfindung auch hinsichtlich weiterer Merkmale und Vorteile anhand von Ausführungsbeispielen beschrieben, die anhand der Abbildungen näher erläutert werden.

Hierbei zeigen:
- Fig. 1a bis 1c: Verfahrensschritte eines ersten erfindungsgemäßen Herstellungsverfahrens;
- Fig. 2a bis 2c: Weitere Verfahrensschritte des ersten Herstellungsverfahrens;
- Fig. 3: Weitere Verfahrensschritte des ersten Herstellungsverfahrens;
- Fig. 4: Weitere Verfahrensschritte des ersten Herstellungsverfahrens;
- Fig. 5: Weitere Verfahrensschritte des ersten Herstellungsverfahrens;
- Fig. 6: Weitere Verfahrensschritte des ersten Herstellungsverfahrens;
- Fig. 7a bis 7c: Verfahrensschritte eines zweiten erfindungsgemäßen Herstellungsverfahrens;
- Fig. 8a bis 8b: Weitere Verfahrensschritte des zweiten Herstellungsverfahrens;
- Fig. 9: Weitere Verfahrensschritte des zweiten Herstellungsverfahrens;
- Fig. 10: Weitere Verfahrensschritte des zweiten Herstellungsverfahrens;
- Fig. 11: Weitere Verfahrensschritte des zweiten Herstellungsverfahrens;
- Fig. 12: Weitere Verfahrensschritte des zweiten Herstellungsverfahrens;
- Fig. 13: Weitere Verfahrensschritte des zweiten Herstellungsverfahrens;
- Fig. 14: Weitere Verfahrensschritte des zweiten Herstellungsverfahrens;
- Fig. 15a bis 15c: Verfahrensschritte eines dritten erfindungsgemäßen Herstellungsverfahrens;
- Fig. 16a bis 16b: Weitere Verfahrensschritte des dritten Herstellungsverfahrens;
- Fig. 17a bis 17b: Weitere Verfahrensschritte des dritten Herstellungsverfahrens;
- Fig. 18a bis 18b: Weitere Verfahrensschritte des dritten Herstellungsverfahrens;
- Fig. 19: Weitere Verfahrensschritte des dritten Herstellungsverfahrens;
- Fig. 20: Weitere Verfahrensschritte des dritten Herstellungsverfahrens;
- Fig. 21: Weitere Verfahrensschritte des dritten Herstellungsverfahrens;
- Fig. 22: Weitere Verfahrensschritte des dritten Herstellungsverfahrens;
- Fig. 23: Zusätzliche elektrolytische Abscheidung von Lot und
- Fig. 24: verfahren zum Aufbringen einer weiteren Schicht.

In der nachfolgenden Beschreibung werden für gleiche und gleichwirkende Teile dieselben Bezugsziffern verwendet.

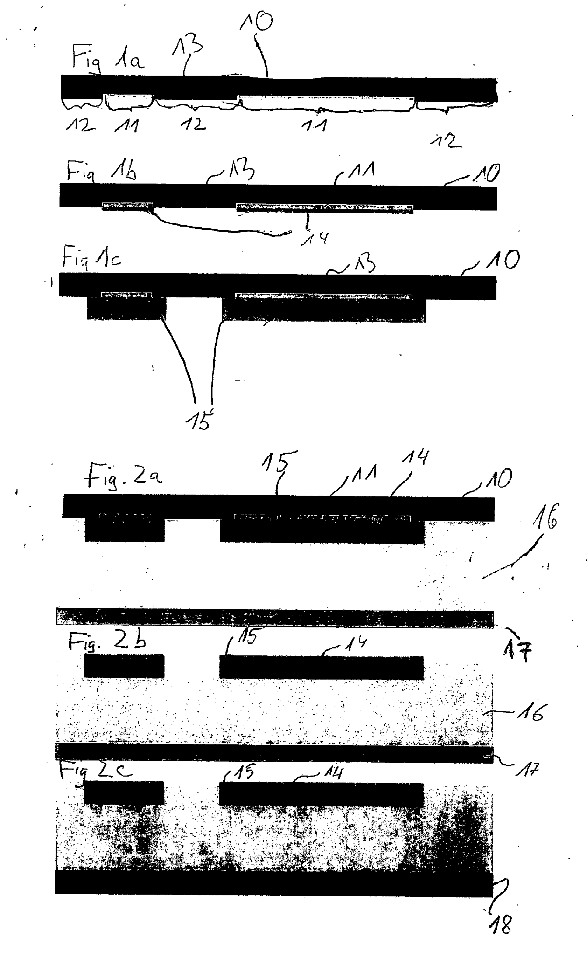

Fig. 1a zeigt zunächst eine strukturierte Elektrode 10 mit Bereichen erhöhter Leitfähigkeit 11 und Bereichen geringerer Leitfähigkeit 12. In der konkreten Ausführungsform sind die Bereiche erhöhter Leitfähigkeit 11 auf einen isolierenden Grundkörper 13 aufgebracht, so dass die Bereiche mit geringerer Leitfähigkeit im Vorliegenden ebenfalls isolierende Bereiche darstellen. Alternativ wäre es auch denkbar, einen leitfähigen Grundkörper bereitzustellen und entsprechend isolierende Bereiche oder Bereiche mit geringerer Leitfähigkeit durch Auftragen beispielsweise eines Isolators bereitzustellen. Die Bereiche erhöhter Leitfähigkeit wären dann beispielsweise zwischen den Bereichen des aufgetragenen Isolators.

Gemäß Fig. 1b wird auf den Bereichen erhöhter Leitfähigkeit 11 eine leitfähige Polymerschicht 14 aufgetragen. Dies kann beispielsweise durch Eintauchen in eine Elektrolytlösung und Anlegen einer Spannung geschehen.

Wie in Fig. 1c zu sehen, wird die leitfähige Polymerschicht 14 mit einer Metallschicht 15, beispielsweise Kupfer, verstärkt. Im Ergebnis weist die Metallschicht 15 im Wesentlichen dieselben Strukturen auf, wie die Bereiche 11 mit erhöhter Leitfähigkeit. Bedingt durch das Herstellungsverfahren sind im vorliegenden Fall allerdings die Strukturen der Metallschicht leicht verbreitert gegenüber den Strukturen der Bereiche erhöhter Leitfähigkeit 11. Eine Verbreiterung oder auch Verengung (je nach Herstellungsverfahren) kann beispielsweise im Bereich von 0,1% oder 1% oder 10% oder auch 50% (jeweils als Untergrenze oder auch Obergrenze einer Strukturbreite) liegen. Es entstehen metallische Strukturen mit sehr hoher Auflösung.

Gemäß Fig. 2a wird die strukturierte Elektrode 10 mit einer Isolationsschicht 16 in Kontakt gebracht, wobei auf der der strukturierten Elektrode 10 gegenüberliegenden Seite der Isolationsschicht 16 eine Klebeschicht 17 angeordnet ist. Die Isolationsschicht 16 kann vorzugsweise eine Folie, insbesondere Polyamidfolie sein.

Die Klebeschicht 17 muss nicht vorgesehen sein. Alternativ oder zusätzlich kann gemäß Fig. 2c eine Metallschicht 18, insbesondere ganzflächig auf der der strukturierten Elektrode 10 gegenüberliegenden Seite der Isolationsschicht 16 angeordnet sein.

In jedem Fall, wie in Fig. 2b und 2c zu sehen, findet ein Transfer der Metallschicht 15 von der Elektrode 10 auf die Isolationsschicht 16 statt. Die Elektrode 10 wird im folgenden Fall von der leitfähigen Polymerschicht 14 und der Metallschicht 15 getrennt, wobei die leitfähige Polymerschicht 14 auf der Metallschicht 15 verbleibt. Alternativ ist es auch denkbar, dass die Elektrode 10 nicht abgetrennt wird, also verbleibt und/oder dass die leitfähige Polymerschicht 14 auf der Elektrode 10 verbleibt und mit dieser abgetrennt wird.

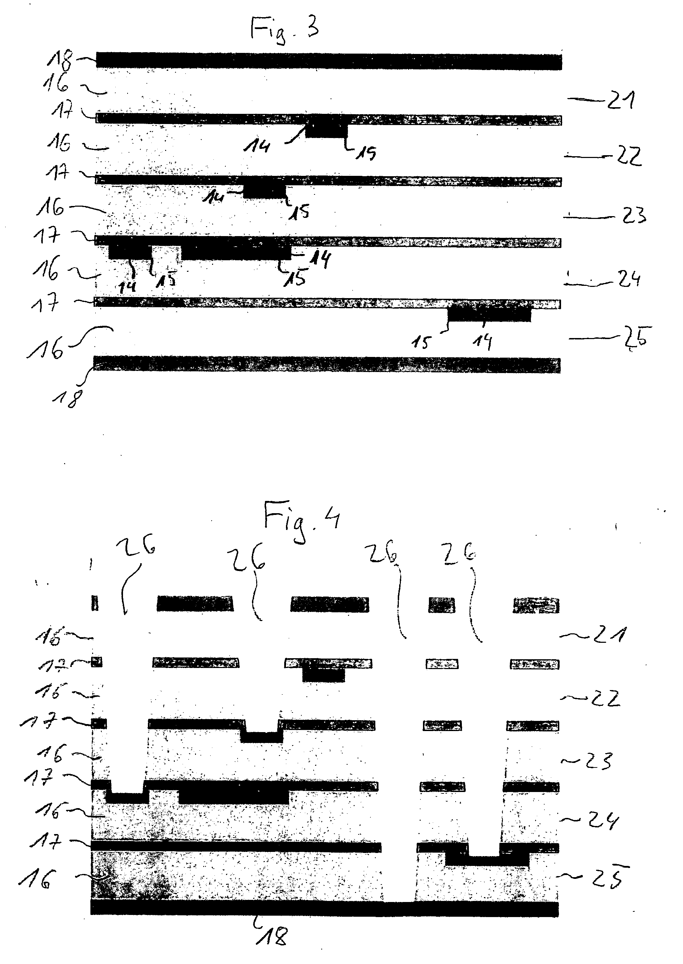

Anschließend können entsprechend dem Verfahren gemäß Fig. 1a bis 1b und 2a bis 2b mehrere Schichtelemente hergestellt werden. Fig. 3 zeigt die Übereinanderordnung von fünf Schichtelementen, konkret einem ersten Schichtelement 21, einem zweiten Schichtelement 22, einem dritten Schichtelement 23, einem vierten Schichtelement 24 und einem fünften Schichtelement 25. Das erste Schichtelement 21 ist auf seiner dem zweiten Schichtelement 22 abgewandten Seite mit einer Metallschicht 18, analog der Metallschicht 18 aus Fig. 2c versehen. Das fünfte Schichtelement ist an seiner vom vierten Schichtelement 24 abgewandten Seite ebenfalls mit einer Metallschicht 18, analog der Metallschicht 18 aus Fig. 2 versehen.

Das erste Schichtelement 21 umfasst im konkreten Beispiel gemäß Fig. 3 eine im Wesentlichen ganzflächige Metallschicht 18, eine Isolationsschicht 16 und eine Klebeschicht 17. Die Schichtelemente 22 bis 24 umfassen jeweils eine Isolationsschicht 16, eine Klebeschicht 17 sowie strukturierte Metallschichten 15 einschließlich leitfähiger Polymerschichten 14. Das fünfte Schichtelement 25 umfasst eine strukturierte Metallschicht 15 einschließlich zugeordneter leitfähiger Polymerschicht 14, eine Isolationsschicht 16 und eine im Wesentlichen ganzflächige Metallschicht 18.

Die Klebeschichten 17 können sich dabei von dem Übereinanderordnen jeweils schon auf der zugeordneten Isolationsschicht 16, insbesondere der zugeordneten Folie, befinden oder alternativ auch separat aufgetragen werden.

Gemäß Fig. 3 weisen die Schichtelemente 21 bis 25 noch die leitfähigen Polymerschichten 14 auf. Diese können alternativ mechanisch, optisch oder chemisch, oder auch thermisch entfernt werden. Dies muss insbesondere dann nicht sein, wenn die Schichten nicht bei anschließenden Hochtemperaturprozessen ausgasen oder sich schädlich verändern, insbesondere unerwünscht verhärten.

Beispielsweise bei Poly-3,4-Ethylendioxidthiophen, das mit Polystyrensulfonat dotiert wird (PEDOT : PSS) wird eine Verhärtung bei Temperaturen über 250°C beobachtet.

Gemäß Fig. 4 werden Ausnehmungen 26 durch eine oder mehrere der Schichtelemente 21 bis 25, beispielsweise mechanisch oder per Laser angefertigt. Im Prinzip können die Ausnehmungen durch beliebig viele der Schichtelemente gehen, konkret verlaufen die Ausnehmungen im vorliegenden Fall durch drei, zwei, fünf und vier Schichtelemente 22 bis 25. Drei der Schichtelemente enden auf Metallschichten 15, wohingegen eine der Ausnehmungen 26 im vorliegenden Fall auf der ganzflächigen Metallschicht 18 des fünften Schichtelements 25 endet. Hierbei wird die jeweilige leitfähige Polymerschicht 14 über den zugeordneten Metallschichten 15 mit entfernt, so dass ein sicherer Kontakt entsteht. Prinzipiell ist es auch denkbar, dass die leitfähige Polymerschicht 14 im Bereich der Ausnehmungen 26 nicht mit entfernt wird.

Anschließend kann insbesondere in einem Galvanikverfahren eine Bekeimung von Wänden der Ausnehmungen 26 mit einem Metall vorgenommen werden. Vorzugsweise ist das Metall für die Bekeimung ein Katalysator, der eine optionale nachfolgende zusätzliche Verstärkung der Schicht mit einem zweiten Metall, insbesondere Kupfer katalysiert. Durch die galvanische Abscheidung vom Metall werden Kontaktierungen 27 gebildet, die Metallschichten 14, 18 verschiedener Schichtelemente 21 bis 25 elektrisch mit der Metallschicht 18 des ersten Schichtelements 21 verbinden. Selbstverständlich ist es alternativ auch denkbar, zwei oder mehr strukturierte Metallschichten 15, beispielsweise auch innerhalb der Mehrlagenleiterplatte, zu verbinden. Beispielsweise können dann in einem ersten Schritt die entsprechenden Ausnehmungen 26 und Durchkontaktierungen 27 bereitgestellt werden, woraufhin in einem nachfolgenden Schritt zusätzliche Schichten oberhalb oder unterhalb angeordnet werden, so dass insgesamt sogenannte "vergrabene" (sich im Inneren der Mehrlagenleiterplatte befindende) Durchkontaktierungen bereitgestellt werden.

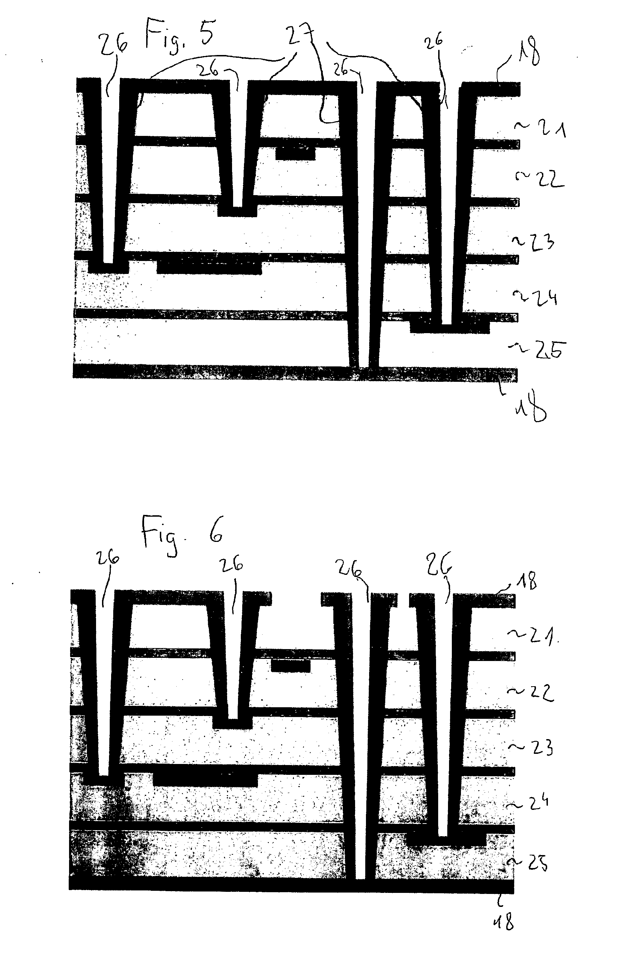

Wie Fig. 6 zu entnehmen ist, können in einem weiteren Schritt die Metallschichten 18 (eine von beiden oder beide) lithografisch oder nasschemisch strukturiert werden, insbesondere da hier die Anforderung an eine Strukturauflösung geringer sein können.

Das nachfolgende alternative Verfahren kann beliebig mit dem Verfahren gemäß der ersten Ausführungsform kombiniert werden.

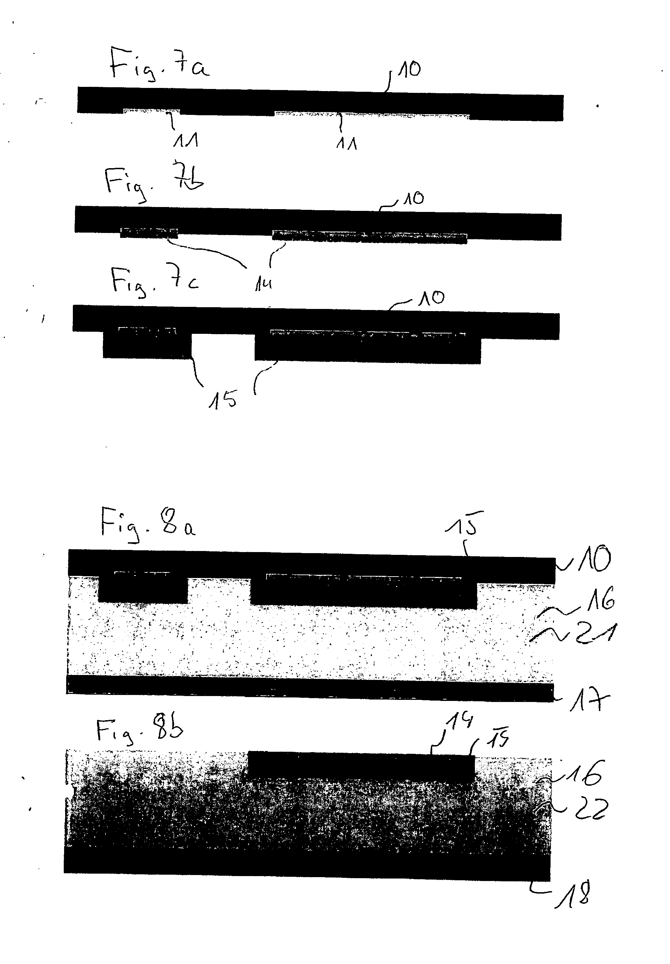

Die Fig. 7a bis 14 zeigen eine zweite Ausführungsform des Herstellungsverfahrens. Die Fig. 7a bis 7c entsprechend den Fig. 1a bis 1c, so dass an dieser Stelle auf die Figurenbeschreibung diesbezüglich verwiesen wird. Weiterhin wird gemäß Fig. 8a analog Fig. 2a ein erstes Schichtelement 21 hergestellt und parallel hierzu ein zweites Schichtelement 22 gemäß Fig. 8b analog Fig. 2c.

Das erste Schichtelement 22 gemäß Fig. 8a besteht somit aus der strukturierten Elektrode 10, einer Isolationsschicht 16 und einer Klebeschicht 17 (in der genannten Reihenfolge übereinander geordnet), wobei zwischen Elektrode 10 und Isolationsschicht 16 eine strukturierte Metallschicht 15 ausgebildet ist (einschließlich leitfähiger Polymerschicht 14).

Das zweite Schichtelement 22 gemäß Fig. 8b besteht aus einer Isolationsschicht 16 und einer im Wesentlichen ganzflächigen Metallschicht 18 auf der einen Seite, wobei auf der anderen Seite eine strukturierte Metallschicht 15 einschließlich leitfähiger Polymerschicht 14 vorgesehen ist.

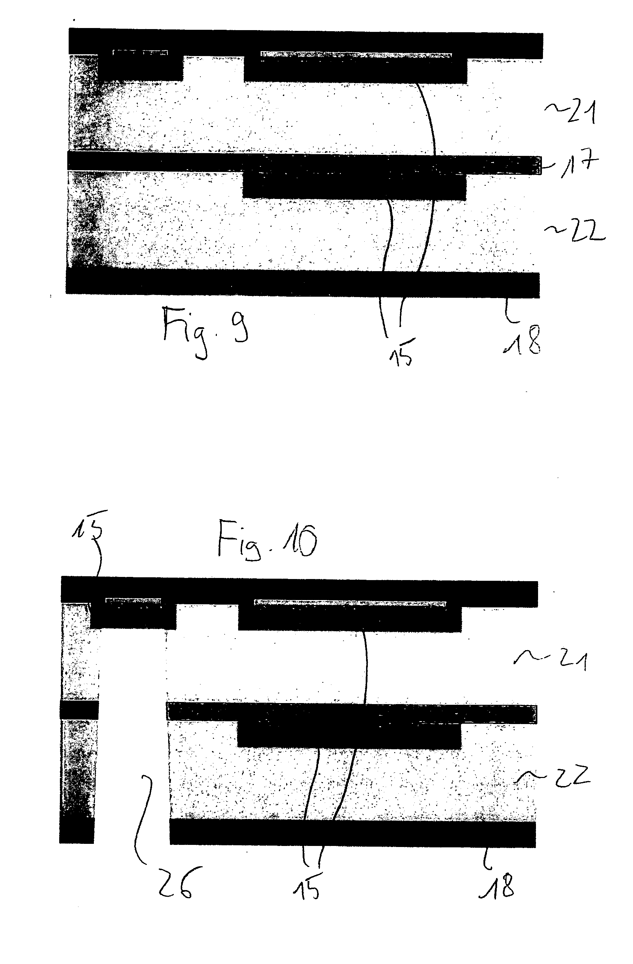

Die Schichtelemente 21, 22 gemäß Fig. 8a und 8b werden dann gemäß Fig. 9 übereinander angeordnet, wobei die Klebeschicht 17 des ersten Schichtelements 21 mit der strukturierten Metallschicht 15 des zweiten Schichtelements 22 verbunden wird (siehe Fig. 9).

Gemäß Fig. 10 wird eine Ausnehmung 26, die durch erstes und zweites Schichtelement 21, 22 bis zur strukturierten Metallschicht 15 des ersten Schichtelementes 21 verläuft, ausgebildet. Die Ausnehmungen können per Laser oder Bohrer hergestellt werden. Bei der Verwendung eines Lasers können zuvor mittels eines anderen Lasers oder eines anderen Bohrers Öffnungen in die ganzflächige Metallschicht 18 des zweiten Schichtelements 22 eingebracht werden.

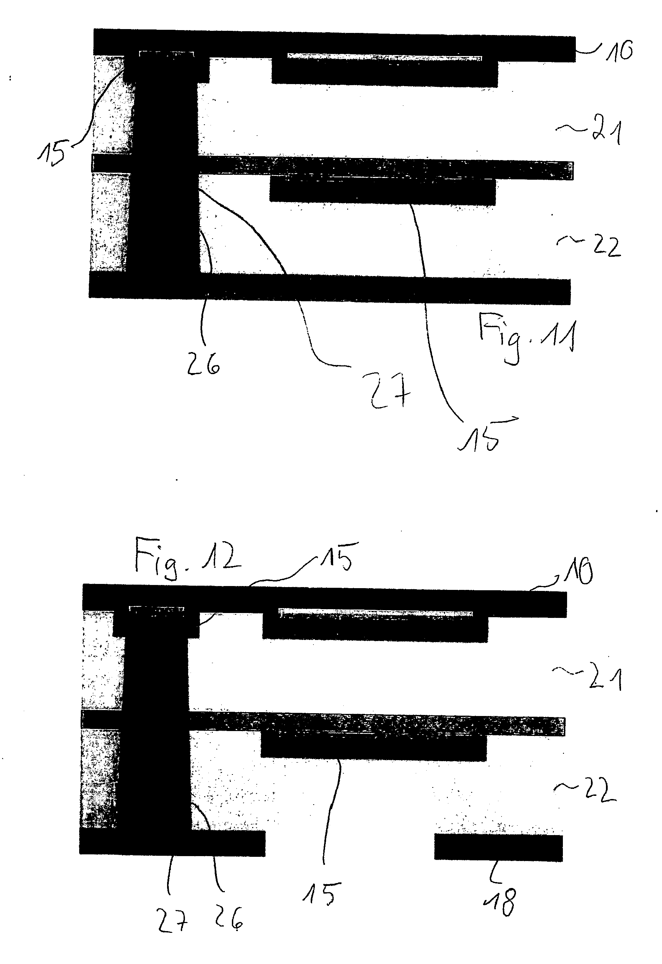

Über die Elektrode 10 (siehe Fig. 11) kann dann in einem Galvanikbad die Ausnehmung 26 derart bestromt werden, dass eine Durchkontaktierung 27 von der Metallschicht 15 ausgehend innerhalb der Ausnehmung 26 aufwächst. Auch an diesem Fall wird vorzugsweise für die Galvanisierung Kupfer eingesetzt. Im Ergebnis wird ein zuverlässiger Kontakt geschaffen.

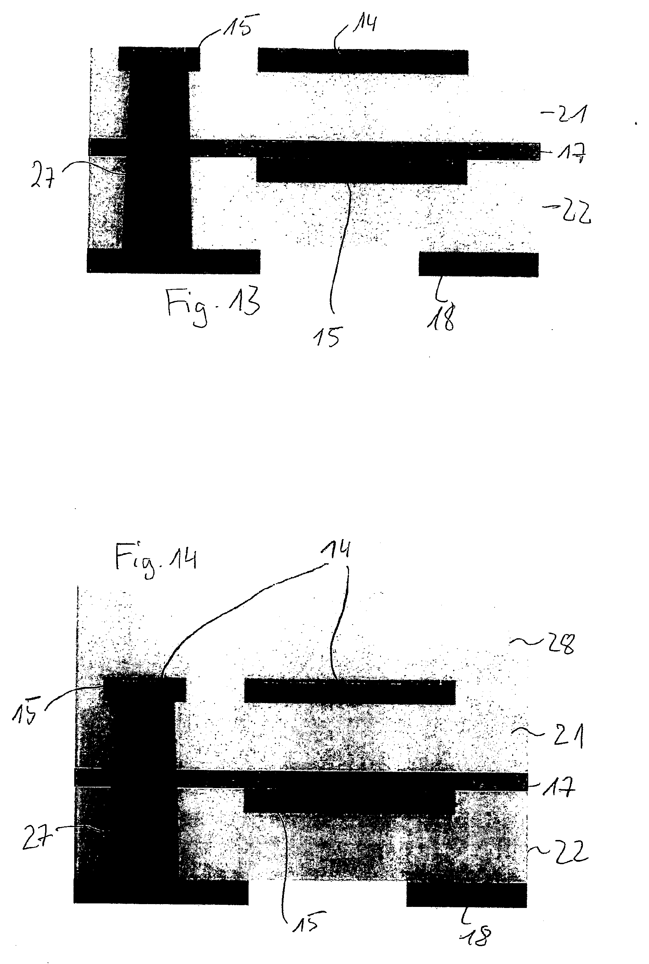

Gemäß Fig. 12 kann die Metallschicht 18 (analog Fig. 6) strukturiert werden. Die Elektrode 10 kann entfernt werden (vgl. Fig. 12 i. V. m. Fig. 13).

Eine Schicht 28 (vgl. Fig. 14) kann über die dem zweiten Schichtelement abgewandte Fläche des ersten Schichtelements 21 bzw. über die strukturierte Metallschicht 15 bzw. leitfähige Polymerschicht 14 des ersten Schichtelements angeordnet werden. Die Schicht 28 dient beispielsweise zur elektrischen Isolation und/oder zum Schutz vor mechanischer Einwirkung und/oder zum Schutz vor Wärmeeinwirkung.

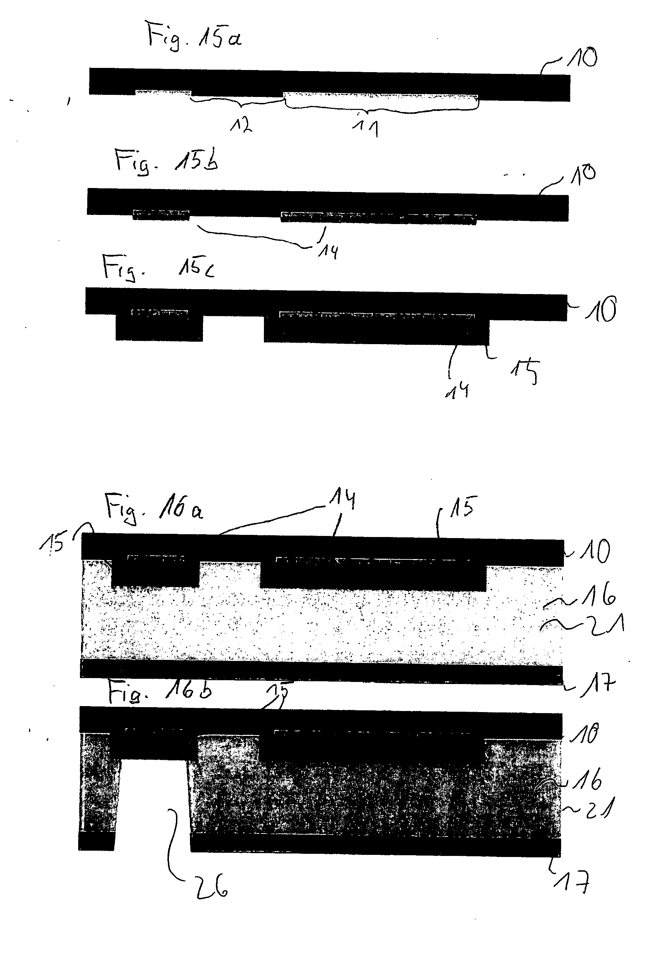

Die Fig. 15 bis 22 zeigen eine weitere Ausführungsform des Herstellungsverfahrens. Auch dieses Verfahren kann mit den bereits zuvor beschriebenen Herstellungsverfahren beliebig kombiniert werden.

Gemäß Fig. 15a bis 15c wird analog Fig. 1a bis 1c eine Elektrode mit leitfähiger Polymerschicht 14 und strukturierter Metallschicht 15 hergestellt. Gemäß Fig. 16a (analog Fig. 2a) wird ein erstes Schichtelement 21 hergestellt. Dieses erste Schichtelement 21 umfasst eine Elektrode 10, eine leitfähige Polymerschicht 14, eine strukturierte Metallschicht 15, eine Isolationsschicht 16 und eine Klebeschicht 17 (in dieser Reihenfolge übereinander angeordnet). Gemäß Fig. 16b wird eine Ausnehmung 26, die durch die Klebeschicht 17 und die Isolationsschicht 16 bis zur Metallschicht 15 verläuft, ausgebildet. Auch hier kann ein Laser oder ein mechanisches Bohrmittel zum Einsatz kommen.

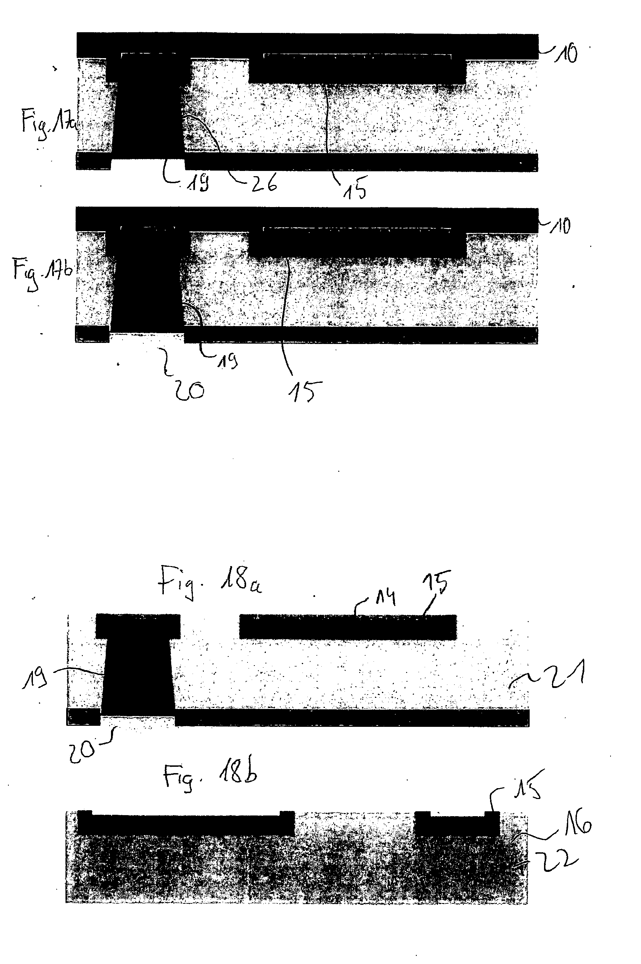

Es wird analog der Beschreibung zu Fig. 11 die Ausnehmung 26 mit einem ersten Metall 19 , insbesondere Kupfer gefüllt. Dazu kann auch hier vorzugsweise ein galvanisches Verfahren zum Einsatz kommen (siehe Fig. 17a).

Gemäß Fig. 17b wird auf das erste Metall 19, insbesondere mittels Galvanik, ein zweites Metall 20 abgeschieden, das einen Schmelzpunkt hat, der unterhalb der Schmelztemperatur des ersten Metalls 19 liegt. Das erste Metall 19 hat vorzugsweise eine Schmelztemperatur von mindestens 600°C, vorzugsweise mindestens 800°C, insbesondere mindestens 1100°C. Das zweite Metall 20 hat vorzugsweise eine Schmelztemperatur von höchstens 1000°C, vorzugsweise höchstens 800°C, insbesondere höchstens 600°C, beispielsweise höchstens 300°C. Beispielsweise kann das zweite Metall 20 Zink und/oder Zinn sein. Es ist auch darauf zu achten, dass die leitfähige Polymerschicht 14, die vorzugsweise aus Polyamid besteht (wie auch bei den anderen Ausführungsformen bzw. im Allgemeinen) sich in seiner Struktur nicht negativ verändert, insbesondere versteift.

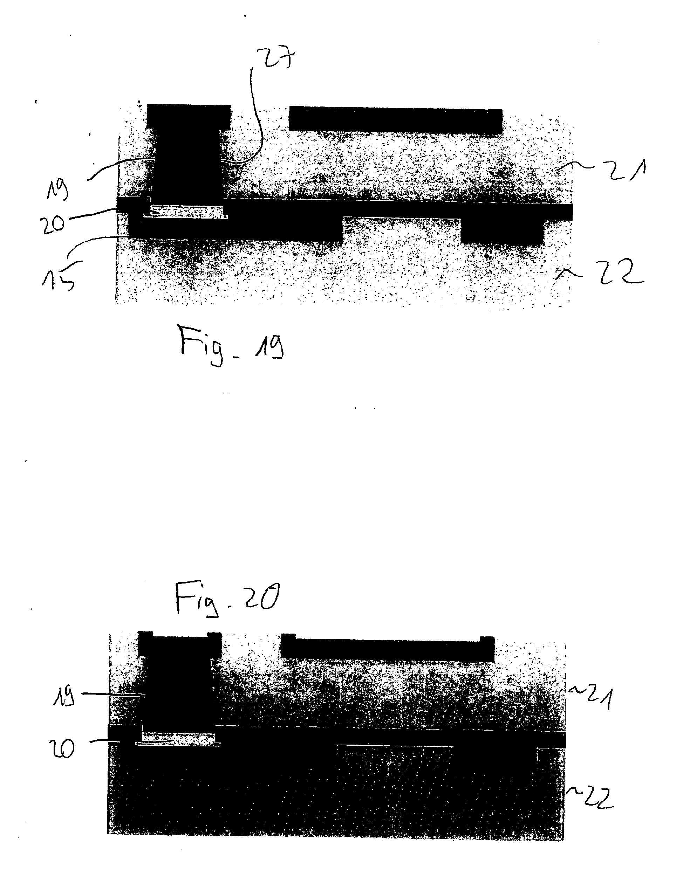

Daraufhin kann die Elektrode 10 entfernt werden (siehe Fig. 18a). Das erste Schichtelement 21 kann mit einem zweiten Schichtelement 22 (vgl. Fig. 18b und Fig. 19) verbunden werden. Das zweite Schichtelement 22 gemäß Fig. 18b umfasst eine Isolationsschicht 16 und eine Metallschicht 15. Eine leitfähige Polymerschicht 14 ist nicht vorgesehen bzw. kann in einem vorangehenden Schritt entfernt werden. Das erste Schichtelement gemäß Fig. 18a wird dann mit dem zweiten Schichtelement gemäß Fig. 18b, wie in Fig. 19 zu sehen, übereinander geordnet. Die übereinander geordneten Schichtelemente 21, 22 werden einer Temperatur ausgesetzt derart, dass das zweite Metall 20 aufgeschmolzen wird und sich dadurch die Durchkontaktierung 27 des ersten Schichtelements 21 dauerhaft und zuverlässig mit der strukturierten Metallschicht 15 des zweiten Schichtelements 22 verbindet.

Die leitfähige Polymerschicht 14 des ersten Schichtelements 21 wird daraufhin (oder davor) entfernt. Wie auch bei den anderen Verfahren kann die leitfähige Polymerschicht insbesondere aus PEDOT bestehen. Das Entfernen der leitfähigen Polymerschicht 14 kann ggf. auch nicht durchgeführt werden.

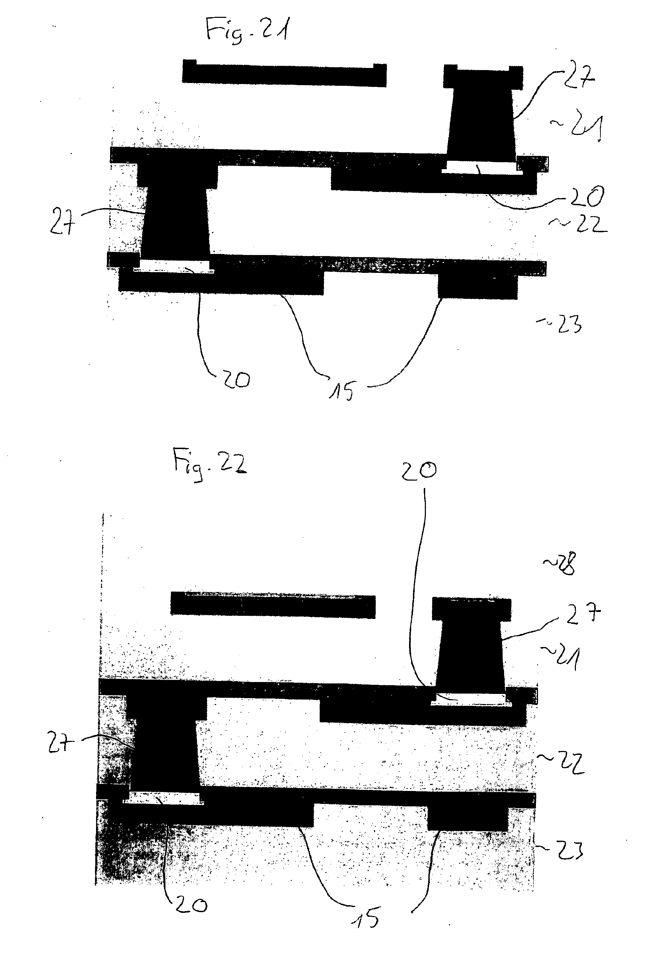

Auf das erste oder zweite Schichtelement 21, 22 kann ein drittes und im Allgemeinen ein weiteres Schichtelement 23 aufgebracht werden (siehe Fig. 21). Auch in diesem Fall (vgl. Fig. 22) kann analog Fig. 14 eine Schicht 28, beispielsweise als Schutz- und/oder Isolationsschicht oberhalb und/oder unterhalb der Gesamtanordnung angebracht werden.

Die Reihenfolge der Prozessschritte kann beliebig variiert werden. Insbesondere sind Ausdrücke wie "daraufhin" oder "dann" im allgemeinen nur zur Erläuterung angegeben und dienen nicht zwingend einer Festlegung der zeitlichen Reihenfolge.

Die jeweiligen Elektroden können nur einmal zum Einsatz kommen (beispielsweise wenn sie während des Herstellungsprozesses zerstört werden) oder auch wieder verwendbar sein. Vorzugsweise handelt es sich um flexible Elektroden, die sich dadurch auszeichnen, dass die leitfähige Polymerschicht vollständig und zerstörungsfrei von der Elektrode entfernt werden kann, ohne dass die Elektrode selbst hierbei beschädigt oder zerstört wird. Die Ablösung der Polymerschicht von der Elektrode kann weiterhin, unabhängig davon, ob eine wieder verwendbare oder eine flexible Elektrode gewählt wird, durch die Beimischung von Zusatzstoffen, insbesondere von flüssigen und gasförmigen Lösungsmitteln, innerhalb eines Monomerbades begünstigt werden.

Vorzugsweise wird die leitfähige Polymerschicht durch Eintauchen der Elektrode in ein Monomerbad bei gleichzeitigem Anlegen einer Spannung hergestellt. Die dabei auftretende Polymerisation kann die leitfähige Polymerschicht erzeugen.

Die zum Einsatz kommenden Elektroden können derart ausgebildet sein, dass eine Elektrodenfläche in Abhängigkeit der gewünschten Struktur der strukturierten Metallschicht bestrombar ist und vorzugsweise mithilfe einer Steuerungseinheit individuell festlegbar ist, so dass mit einer flexiblen Elektrode in nacheinander ablaufenden Verfahrensschritten strukturierte Metallschichten bzw. leitfähige Polymerschichten unterschiedlicher Geometrie und/oder Form mit der gleichen Elektrode erzeugbar sind.

Alternativ kann anstelle von Kupfer zur Herstellung der Metallschichten 15, 18 oder der Durchkontaktierung 27 auch ein weiteres Metall, beispielsweise Silber, Platin, Palladium und/oder Gold zum Einsatz kommen.

Beispielsweise das Ablösen der strukturierten Elektrode von einer Schicht kann in einem Rolle-zu-Rolle-Verfahren durchgeführt werden.

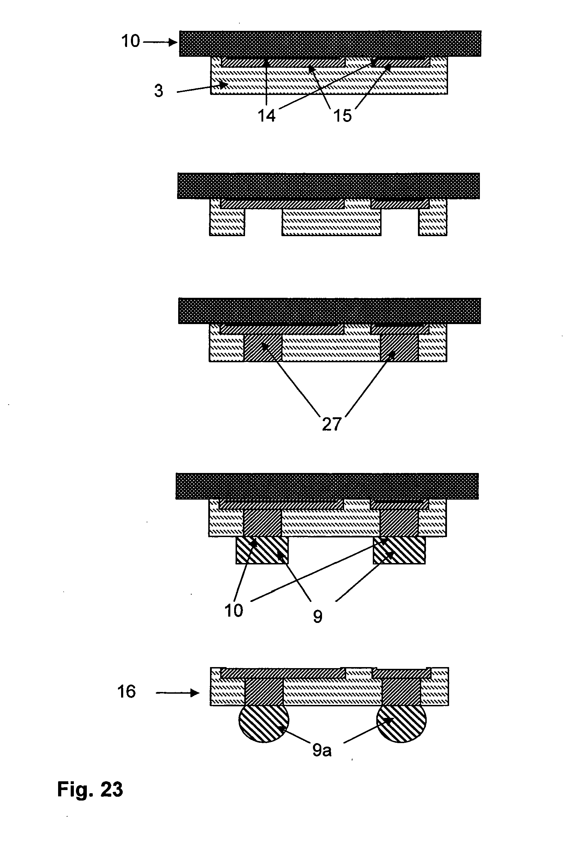

In Figur 23 ist ein Verfahren zur zusätzlichen Abscheidung eines Lotes 9 dargestellt. Zunächst wird in bereits beschriebener Weise ein leitfähiger Polymerfilm 14 auf einer Elektrode 10 abgeschieden. Anschließend folgt ein Galvanisierungsschritt, bei dem eine strukturierte Kupferschicht 15 auf der Polymerschicht 14 abgeschieden wird. Schließlich wird als Isolationsschicht 16 eine Polymidschicht aufgebracht. Nach dem Einbringen von Kontaktlöchern und dem Durchkontaktieren, bei dem Kupfer ebenfalls im Wege einer Galvanisierung abgeschieden wird, erfolgt ein weiterer Prozessschritt, mit dem durch elektrolytische Abscheidung die Durchkontaktierungen 27 mit einer Lotschicht 9, insbesondere einem Zinn-Silber-Lot, beschichtet werden. In diesem Zusammenhang ist es denkbar, im Anschluss an das Aufbringen eines Lots 9, dieses durch Aufschmelzen in Glycerin zu Lotbällen 9a zu formen.

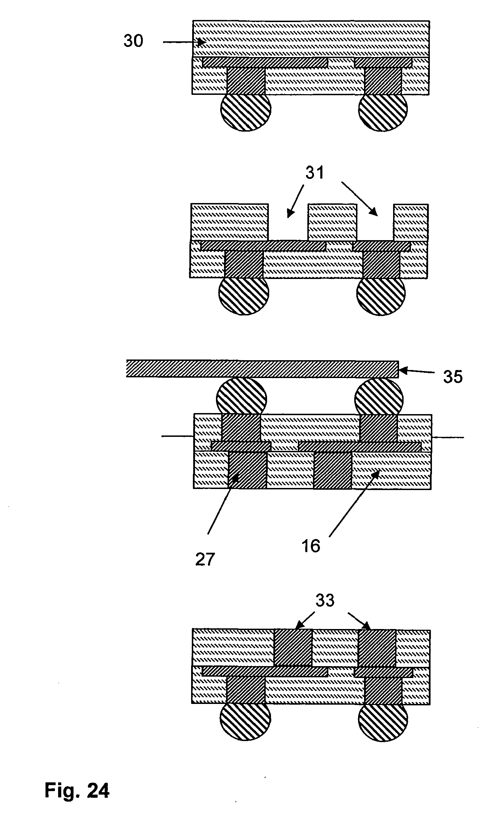

In Figur 24 ist eine isolierende Polymidschicht 16 dargestellt, die über eine strukturierte Kupferschicht 15 und Durchkontaktierungen 27 verfügt. Auf den Durchkontaktierungen 27 ist ein Lot 9 abgeschieden worden und wie zuvor erläutert zu Lotbällen 9a geformt worden.
In Ergänzung zu den bereits beschriebenen Verfahrensschritten wird nunmehr auf die Kupferbahnen 15 eine zweite Polymidschicht 30 als Isolationsschicht 16 auflaminiert. Daraufhin werden weitere Kontaktlöcher 31, insbesondere durch Laserbohren in die zweite Polymidschicht 30 eingebracht. Diese weiteren Kontaktlöcher 31 werden im Wege eines Galvanisierungsprozesses oder mehrerer Galvanisierungsprozesse mit einer Rückseitenmetallschicht 32, die entweder ebenfalls Kupfer oder auch mehrere Metalle, wie etwa Kupfer, Nickel und/oder Gold aufweist, gefüllt. Die Oberfläche 33 der weiteren Durchkontaktierungen 34 kann als Bondfläche genutzt oder galvanisch mit einem Lot 9 bzw. Lotbällen 9a versehen werden.
Zur Herstellung eines elektrischen Anschlusses 35 kann ein beliebiges aus demn Stand der Technik bekanntes verfahren verwendet werden.

An dieser Stelle sei darauf hingewiesen, dass alle oben beschriebenen Teile für sich alleine gesehen und in jeder Kombination, insbesondere die in den Zeichnungen dargestellten Details, als erfindungswesentlich beansprucht werden. Abänderungen hiervon sind dem Fachmann geläufig.

### Bezugszeichenliste:

- 9: Lot
- 9a: Lotball
- 10: Elektrode
- 11: Bereich erhöhter Leitfähigkeit
- 12: Bereich geringerer Leitfähigkeit
- 13: Isolierender Grundkörper
- 14: Leitfähige Polymerschicht
- 15: Metallschicht (strukturierte)
- 16: Isolationsschicht
- 17: Klebeschicht
- 18: Metallschicht
- 19: Erstes Metall
- 20: Zweites Metall
- 21: Erstes Schichtelement
- 22: Zweites Schichtelement
- 23: Drittes Schichtelement
- 24: Viertes Schichtelement
- 25: Fünftes Schichtelement
- 26: Ausnehmung
- 27: Durchkontaktierung
- 28: Schicht
- 29: Wand
- 30: zweite Polymidschicht
- 31: weitere Kontaktlöcher
- 32: Rückseitenmetallschicht
- 33: Oberfläche der weiteren Durchkontaktierungen
- 34: weitere Durchkontaktierungen
- 35: elektrischer Anschluss

## Patentansprüche

1. Verfahren zur Herstellung einer Leiterplatte, umfassend die Schritte:
a) Bereitstellen einer ersten Elektrode (10), deren Oberfläche mindestens bereichsweise aus leitfähigem Polymer gebildet ist oder wird und die mindestens einen Bereich (11) einer vorgegebenen Struktur mit gegenüber den übrigen Bereichen erhöhter Leitfähigkeit aufweist;
b) Aufbringen einer ersten Metallschicht (15) auf das Polymer durch Galvanisieren derart, dass die Metallschicht (15) die Struktur des Bereichs (11) mit erhöhter Leitfähigkeit im Wesentlichen übernimmt;
c) Bereitstellen einer ersten Isolationsschicht (16);
d) Übereinanderanordnung von erster Metallschicht (15) und erster Isolationsschicht (16); und
e) Schaffung einer durch die Isolationsschicht (16) durchgehenden Ausnehmung (26), die zumindest teilweise auch durch die erste Metallschicht (15) begrenzt ist.

2. Verfahren nach Anspruch 1,
**dadurch gekennzeichnet, dass**
im Schritt a) die Elektrode (10) aus einem leitfähigen Material, insbesondere Metall bereitgestellt wird, wobei dessen Oberfläche mindestens einen Oberflächenbereich einer vorgegebenen Struktur mit gegenüber den übrigen Oberflächenbereichen erhöhter Leitfähigkeit aufweist und mit Polymer beschichtet wird.

3. Verfahren nach Anspruch 1 oder 2,
**dadurch gekennzeichnet, dass**
im Schritt b) im Wesentlichen nur oberhalb des mindestens einen Bereichs (11) mit erhöhter Leitfähigkeit Polymer aufgebracht wird.

4. Verfahren nach einem der vorhergehenden Ansprüche,
**dadurch gekennzeichnet, dass**
zumindest ein Teil der Bereiche (11) mit erhöhter Leitfähigkeit in Kontakt mit einem Elektrolyten gebracht werden und über der Elektrode (10) ein Stromfluss durch den Elektrolyten erzeugt wird, wobei auf den mit dem Elektrolyten in Kontakt gebrachten Bereichen (11) mit erhöhter Leitfähigkeit eine leitfähige Polymerschicht (14) der vorgegebenen Struktur gebildet wird.

5. Verfahren nach Anspruch 1,
**dadurch gekennzeichnet, dass**
im Schritt b) die Elektrode (10) ganzflächig mit leitfähigem Polymer beschichtet wird, wobei das Polymer derart ausgewählt und/oder bezüglich seiner Dicke eingestellt wird, dass beim galvanischen Aufbringen des Metalls nur oberhalb des mindestens einen Bereichs mit erhöhter Leitfähigkeit ein ausreichender Strom für eine galvanische Abscheidung des Metalls fließt.

6. Verfahren nach einem der vorhergehenden Ansprüche,
**dadurch gekennzeichnet, dass**
im Schritt b) das leitfähige Polymer von den übrigen Teilen der Elektrode (10) entfernt wird, bevor die Metallschicht (15) aufgetragen wird.

7. Verfahren nach einem der vorhergehenden Ansprüche,
**dadurch gekennzeichnet, dass**
im Schritt b) das leitfähige Polymer auf der Elektrode (10) verbleibt, wenn die Metallschicht (15) aufgetragen wird.

8. Verfahren nach einem der vorhergehenden Ansprüche,
**dadurch gekennzeichnet, dass**
Wände (29) der mindestens einen Ausnehmung (26) zumindest bereichsweise mit einem Metall belegt werden.

9. Verfahren nach Anspruch 8,
**dadurch gekennzeichnet, dass**
das Metall ein Katalysator ist, der die galvanische Abscheidung eines weiteren Metalls ermöglicht und/oder begünstigt.

10. Verfahren nach einem der vorhergehenden Ansprüche,
**dadurch gekennzeichnet, dass**
an die erste Elektrode (10) und/oder eine weitere Elektrode eine Spannung angelegt wird und in Kontakt mit einem Elektrolyten gebracht wird, so dass die Ausnehmung zumindest teilweise durch galvanische Abscheidung mit einem ersten Metall (19), insbesondere Kupfer gefüllt wird.

11. Verfahren nach einem der vorhergehenden Ansprüche,
**dadurch gekennzeichnet, dass,**
insbesondere durch galvanische Abscheidung, ein Metall (20) in die Ausnehmung (26) eingebracht wird, das eine geringere Schmelztemperatur als das Metall der ersten Metallschicht (15) und ggf. als das erste Metall (19) aufweist.

12. Verfahren nach Anspruch 11,
**dadurch gekennzeichnet, dass**
die Leiterplatte einer Temperatur ausgesetzt wird, die geringer als die Schmelztemperatur der Metalle der zu kontaktierenden Metallschichten ist und zugleich größer als die Schmelztemperatur des zweiten Metalls (20) ist.

13. Verfahren nach einem der vorhergehenden Ansprüche,
**dadurch gekennzeichnet, dass**
die Leiterplatte oberseitig und/oder unterseitig im Wesentlichen ganzflächig mit Metall beschichtet wird.

14. Verfahren nach Anspruch 10,
**dadurch gekennzeichnet, dass**
die mit Metall beschichtete Oberseite und/oder Unterseite nasschemisch und/oder lithografisch strukturiert wird.

15. Verfahren nach einem der vorhergehenden Ansprüche,
**dadurch gekennzeichnet, dass**
auf der, der ersten Metallschicht (15) abgewandten Seite der Isolationsschicht (16), eine zweite Metallschicht, insbesondere hergestellt analog der ersten Metallschicht (15), angeordnet wird.

16. Verfahren nach einem der vorhergehenden Ansprüche,
**dadurch gekennzeichnet, dass**
mindestens eine weitere Isolationsschicht und/oder Metallschicht auf der Leiterplatte angeordnet wird, wobei sich vorzugsweise je eine Isolationsschicht mit einer Metallschicht abwechselt.
